# EUROPEAN PATENT SPECIFICATION

(11) **EP 3 183 739 B1**
(45) Date of publication and mention of the grant of the patent: **28.08.2024**
(21) Application number: 15750300.4
(22) Date of filing: 30.07.2015
(51) Int. Cl.: H01J 37/06, H01J 37/305, B22F 10/28, B22F 10/32, B22F 12/13, B22F 12/45, B22F 12/70, B29C 64/153, B33Y 10/00, B33Y 30/00

(54) **ENHANCED ELECTRON BEAM GENERATION**
VERBESSERTE ERZEUGUNG VON ELEKTRONENSTRAHLEN
GÉNÉRATION AMÉLIORÉE DE FAISCEAU D'ÉLECTRONS

(30) Priority: 22.08.2014 US 201462040761 P; 25.06.2015 US 201514750793
(43) Date of publication of application: 28.06.2017
(73) Proprietor: ARCAM AB, 431 37 Mölndal (SE)
(72) Inventor: FAGER, Mattias, S-413 08 Göteborg (SE)
(74) Representative: Hafner & Kohl PartmbB
(86) International application number: PCT/EP2015/067553
(87) International publication number: WO 2016/026668

(56) References cited:
- WO-A1-2013/092997
- WO-A1-2013/167194
- JP-A- 2003 241 394
- JP-A- H05 171 423
- JP-A- S59 839
- US-A1- 2006 141 089
- US-A1- 2006 145 381
- US-A1- 2006 157 892
- US-A1- 2006 228 248
- US-A1- 2010 310 404
- US-A1- 2013 162 134
- US-A1- 2013 216 959
- US-A1- 2013 233 846
- US-A1- 2013 300 286
- --- ET AL: "The Quanta FEG User Operation Manual", 30 January 2007 (2007-01-30), XP055457976, Retrieved from the Internet <URL:http://utw10193.utweb.utexas.edu/InstrumentManuals/QuantaManual.pdf> [retrieved on 20180309]
- SEIJI MOTOJIMA ET AL: "CHEMICAL VAPOR GROWTH OF LaB6 WHISKERS AND CRYSTALS HAVING A SHARP TIP", J OF CRYSTAL GROWTH,, vol. 44, no. 1, 1 August 1978 (1978-08-01), pages 106 - 109, XP001284583

## Description

### BACKGROUND

### Related Field

Various embodiments of the present invention relate to a method for forming a three- dimensional article, an apparatus for forming a three-dimensional article, a program element and a computer readable medium.

### Description of Related Art

Freeform fabrication or additive manufacturing is a method for forming three- dimensional articles through successive fusion of chosen parts of powder layers applied to a worktable. A method and apparatus according to this technique is disclosed in US 2009/0152771.

Such an apparatus may comprise a work table on which the three-dimensional article is to be formed, a powder dispenser, arranged to lay down a thin layer of powder on the work table for the formation of a powder bed, an energy beam source for delivering an energy beam spot to the powder whereby fusion of the powder takes place, elements for control of the energy beam spot over the powder bed for the formation of a cross section of the three-dimensional article through fusion of parts of the powder bed, and a controlling computer, in which information is stored concerning consecutive cross sections of the three-dimensional article. A three-dimensional article is formed through consecutive fusions of consecutively formed cross sections of powder layers, successively laid down by the powder dispenser.

When building three-dimensional articles with additive manufacturing, which is using en electron beam source for melting the material, contamination of the vacuum chamber and/or the electron beam source may be a problem. The contamination may be very much material dependent. Some materials outgas/evaporate very little when being fused or melted, which may be taken care of by the vacuum pump system. However, other materials may outgas/evaporate very much when being fused or melted, which may affect the electron beam source negatively or in worst cases may stop the electron beam generation, which may be a problem. When using an electron beam for delivering energy to the material to be fused in additive manufacturing it is desirable to make it possible to use any type of material irrespective of the evaporation degree of the material when being melted/fused. The document WO 2013 167 194 A1 discloses an additive manufacturing method for forming a three-dimensional article, wherein different types of material are used to form the object.

### BRIEF SUMMARY

Having this background, an object of the invention is to provide methods and associated systems that enable additive manufacturing with the use of an electron beam source which is insensitive to the evaporation degree of the material to be melted and/or the amount of contaminants in the vicinity of the electron beam source. The above-mentioned object is achieved by the features according to the claims contained herein.

Claim 1 provides a method for forming a three-dimensional article through successively depositing individual layers of powder material that are fused together with an electron beam from an electron beam sources so as to form the article.

An exemplary and non-limiting advantage of this method is that the gas pressure inside the second section prohibits particles/gas molecules from entering into the electron beam source, which in turn may increase the stability of the manufacturing process and increase the freedom to choose powder material which otherwise may be harmful for the electron beam source.

In another exemplary embodiment the second section is an electron beam column. In this embodiment the electron beam column is attached onto the first section of the vacuum chamber.

The cathode in the electron beam source is made of a rare earth metal hexaboride. The rare earth metal hexaboride may for instance be Lanthanum hexaboride. The the gas is hydrogen gas for stimulating electron emission from the cathode.

An exemplary and non-limiting advantage of using hydrogen together with a cathode in the electron beam source made of an alkaline earth metal hexaboride or a rare earth metal hexaboride is that hydrogen not only prevents foreign paticles to enter the electron beam column where the foreign particles may harm the cathode element, but the presence of hydrogen in the vicinity of the cathode element made of an alkaline earth metal hexaboride or a rare earth metal hexaboride may stimulate the emission from such a cathode material.

In yet another example embodiment a first electron beam source is provided in the second section, which second section is provided with a gas inlet and wherein a second electron beam source is provided in a third section lacking the gas inlet, wherein the third section is openly connected to the first section.

An exemplary and non-limiting advantage of this embodiment is that the first electron beam source provided with the gas inlet may be used in such melting/heating occasions where one may suspect particles/molecules to enter the electron beam column. The gas in the second section may prohibit such particles/molecules to enter the electron beam column. For instance the first electron beam source with the gas inlet may be used in preheating of powder material where powder lifting may occur. In an alternative embodiment the first electron beam source may be used for specific materials only where one may suspect a higher degree of outgassing material. The second electron beam source without the gas inlet may be used in heating/melting occasions where the likelihood of foreign particles/molecules to enter the electron beam column is very small.

In still another example embodiment at least one scan line in at least a first layer of at least a first three-dimensional article is fused with a first electron beam from the first electron beam source and at least a one scan line in a second layer of the at least first three-dimensional article is fused with a second energy beam from the second energy beam source. An exemplary and non- limiting advantage of this embodiment is that the second energy beam source may be an electron beam source, a laser source or any other suitable means for melting the powder material.

In another example embodiment the first electron beam may be used for melting and/or fusing the powder material and the second energy beam source may be used for pre heating the powder material and/or post heating fused powder. An exemplary and non-limiting advantage of this embodiment is that different fusing/heating sources may be alternated throughout a build. The pre heating and post heat treatment may for instance be made with a laser beam source, a resistive heater or an infrared heater.

In still another example embodiment the scan lines in at least one layer of at least a first three-dimensional article are fused with a first electron beam from the first electron beam source and the scan lines in at least one layer of at least a second three-dimensional article is fused with a second energy beam from the second energy beam source. An exemplary and non-limiting advantage of this embodiment is that different articles built simultaneously may be fused with different energy beam sources. A first part may be built with an electron beam source and a second part with a laser beam source.

In claim 9 it is provided a program element configured and arranged when executed on a computer to implement a method for forming a three-dimensional article through successively depositing individual layers of powder material that are fused together so as to form the article.

In claim 10 it is provided a computer readable medium having stored thereon the program element mentioned above.

In claim 11 it is provided a an apparatus for forming a three-dimensional article through successively depositing individual layers of powder material that are fused together with an electron beam from an electron beam source.

The cathode in the electron beam source in the apparatus is made of a rare earth metal hexaboride.

The gas is hydrogen gas for stimulating electron emission from the cathode made of a rare earth metal hexaboride. An advantage of this is that the gas supply not only prohibits foreign particles/molecules to enter the electron beam column but also stimulates the emission.

### BRIEF DESCRIPTION OF THE SEVERAL VIEWS OF THE DRAWINGS

Having thus described the invention in general terms, reference will now be made to the accompanying drawings, which are not necessarily drawn to scale, and wherein:
FIG. 1 depicts a first example embodiment of an additive manufacturing apparatus according to the present invention;
FIG. 2 depicts a schematic flow chart of a method according to the present invention.
FIG. 3 is a block diagram of an exemplary system 1020 according to various embodiments;
FIG. 4A is a schematic block diagram of a server 1200 according to various embodiments; and
FIG. 4B is a schematic block diagram of an exemplary mobile device 1300 according to various embodiments.

### DETAILED DESCRIPTION OF VARIOUS EMBODIMENTS

Various embodiments of the present invention will now be described more fully hereinafter with reference to the accompanying drawings, in which some, but not all embodiments of the invention are shown. Indeed, embodiments of the invention may be embodied in many different forms and should not be construed as limited to the embodiments set forth herein. Unless otherwise defined, all technical and scientific terms used herein have the same meaning as commonly known and understood by one of ordinary skill in the art to which the invention relates. The term "or" is used herein in both the alternative and conjunctive sense, unless otherwise indicated. Like numbers refer to like elements throughout.

Still further, to facilitate the understanding of this invention, a number of terms are defined below. Terms defined herein have meanings as commonly understood by a person of ordinary skill in the areas relevant to the present invention. Terms such as "a", "an" and "the" are not intended to refer to only a singular entity, but include the general class of which a specific example may be used for illustration. The terminology herein is used to describe specific embodiments of the invention, but their usage does not delimit the invention, except as outlined in the claims.

The term "three-dimensional structures" and the like as used herein refer generally to intended or actually fabricated three-dimensional configurations (e.g., of structural material or materials) that are intended to be used for a particular purpose. Such structures, etc. may, for example, be designed with the aid of a three-dimensional CAD system.

The sources of charged particle beam includes an electron gun or a linear accelerator.

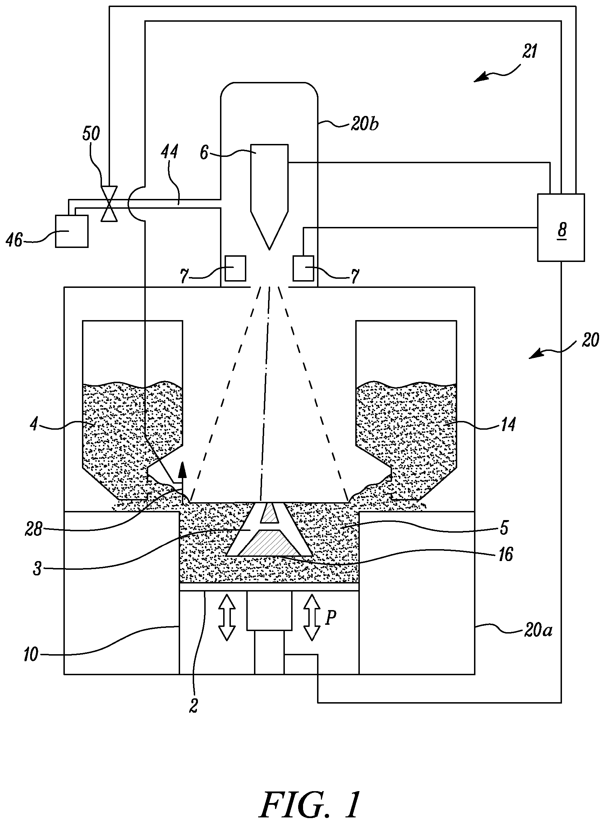

Figure 1 depicts an example embodiment of a freeform fabrication or additive manufacturing apparatus 21 according to the present invention. The apparatus 21 comprising an electron beam gun 6; electron beam optics 7; two powder hoppers 4, 14; a build platform 2; a build tank 10; a powder distributor 28; a powder bed 5; a vacuum chamber 20, a control unit 8, and a gas inlet 44.

The vacuum chamber 20 may be capable of maintaining a vacuum environment by means of or via a vacuum system, which system may comprise a turbo molecular pump, a scroll pump, an ion pump and one or more valves which are well known to a skilled person in the art and therefore need no further explanation in this context. The vacuum system may be controlled by the control unit 8. Individual layers of powder material that are fused together are provided in a first section 20a of the vacuum chamber 20. The electron beam source is provided in a second section 20b of the vacuum chamber 20, wherein the first section 20a and the second section 20b are openly connected to each other.

In an alternative construction, not part of the invention as claimed, a thin beryllium window may be provided between the first and second sections, i.e., separating the first and second sections from each other. In such a construction a first vacuum condition may be provided in the first section and a second vacuum condition may be provided in the second section, where the first and second vacuum conditions are independent of each other.

The electron beam gun 6 is generating an electron beam which is used for pre heating of the powder, melting or fusing together powder material provided on the build platform 2 and/or post heat treatment of the already fused powder material. The electron beam gun 6 is provided in the second section 20b of the vacuum chamber 20. The control unit 8 may be used for controlling and managing the electron beam emitted from the electron beam gun 6.

The electron beam optics 7 may comprise at least one focusing coil, at least one deflection coil 7 and optionally at least one coil for astigmatic correction.

An electron beam power supply (not shown) may be electrically connected to the control unit 8. In an example embodiment of the invention the electron beam gun 6 may generate a focusable electron beam with an accelerating voltage of about 15-60kV and with a beam power in the range of 3-10kW. The pressure in the first section 20a of the vacuum chamber 20 may be 1×10⁻³ mbar or lower when building the three-dimensional article by fusing the powder layer by layer with the electron beam.

An electron beam generation cathode is a thermionic cathode made of a rare earth metal hexaboride such as Scandium hexaboride, Yttrium hexaboride, Lanthanum hexaboride, Cerium hexaboride, Praseodymium hexaboride, Neodymium hexaboride, Promethium hexaboride, Samarium hexaboride, Europium hexaboride, Gadolinium hexaboride, Terbium hexaboride, Dysprosium hexaboride, Holmium hexaboride, Erbium hexaboride, Thulium hexaboride, Ytterbium haxaboride, Lutetium hexaboride.

An electron beam may be directed from the at least one electron beam source over the work table to fuse in first selected locations according to a model to form a first cross section of a three-dimensional article while supplying a gas to the second section of the vacuum chamber. The beam is directed over the build platform 2 from instructions given by the control unit 8. In the control unit 8 instructions for how to control the electron beam for each layer of the three- dimensional article is stored. The first layer of the three dimensional article 3 may be built on the build platform 2, which may be removable, in the powder bed 5 or on an optional start plate. The start plate may be arranged directly on the build platform 2 or on top of a powder bed 5 which is provided on the build platform 2. The gas may be stored in a gas tank 40 and connected to the second section 20b of the vacuum chamber 20 via a pipe 44. A valve 50 may be provided on the pipe 44, which may be controlled by the control unit 8.

The gas that is provided into the second section 20b of the vacuum chamber is hydrogen.

The pressure in the second section 20b of the vacuum chamber 20 is somewhat higher than the pressure in the first section 20a of the vacuum chamber 20 during manufacturing of the three dimensional article. In an example embodiment the pressure in the second section 20b may be 2×10⁻³ mbar, while the pressure in the first section 20a may be 1×10⁻³ mbar. The control unit may control via the valve 50 the amount of gas that will be provided into the second section for maintaining a sufficient predetermined pressure in the second section.

In an example embodiment a mean pressure in the second section 20b is higher than or equal to a mean pressure in the first section 20a during the manufacturing of the three-dimensional article.

In an example embodiment the second section 20b of the vacuum chamber 20 is the electron beam column. The pipe 44 may be arranged between the cathode and anode in the electron beam column. Gas is leaked into the electron beam column in the form of hydrogen. Using, as claimed, a cathode element for generating the electron beams made of a rare earth metal hexaboride, such gas which is leaked into the electron beam column may also have the effect of suppressing unwanted particles/gas molecules into the electron beam columr in addition to stimulating the emission of electrons from the cathode element. From experiments it has been validated that the emission is increased from a Lanthanum hexaboride cathode element if the electron beam column is provided with a hydrogen gas compared to if the electron beam column is not provided with hydrogen gas, i.e., essentially free from residual gases.

In yet another example embodiment a first electron beam source may be provided in the second section, which second section is provided with a gas inlet and wherein a second electron beam source is provided in a third section lacking the gas inlet, wherein the third section is openly connected to the first section.

The advantage of this embodiment is that the first electron beam source provided with the gas inlet may be used in such melting/heating occasions where one may suspect particles/molecules to enter the electron beam column. This may be the case when special types of powder materials are to be fused together. The gas in the second section may prohibit such particles/molecules to enter the electron beam column. Since the pressure in the second section is at least equal of higher than the pressure in the build chamber (first section)., particles emanating from the building process will not strive to enter the second section as is normally the case when the pressure in the second section comprising the electron beam column is much lower than the pressure in the rest of the vacuum chamber. For instance the first electron beam source with the gas inlet may be used in preheating of powder material where powder lifting may occur. In an alternative embodiment the first electron beam source may be used for specific materials only where one may suspect a higher degree of outgassing material. The second electron beam source without the gas inlet may be used in heating/melting occasions where the likelihood of foreign particles/molecules to enter the electron beam column is very small.

In still another example embodiment at least one scan line in at least a first layer of at least a first three-dimensional article is fused with a first electron beam from the first electron beam source and at least a one scan line in a second layer of the at least first three-dimensional article is fused with a second energy beam from the second energy beam source

The advantage of this embodiment is that the second energy beam source may be an electron beam source, a laser source or any other suitable means for melting the powder material. Different layer of an article may require different types of energy beam characterization. By this embodiment it is also possible to tailor the material properties by switching between different energy beam sources for different layers of the part to be manufactured.

The first electron beam source may be used for melting/fusing the powder material while a second energy beam source may be used for preheating the powder material or post heat treatment of already fused powder material.

The second energy beam source may be a resistive heater or an infrared heater for preheating the powder material or post heat treatment of already fused powder material.

In another example embodiment of the present invention the scan lines in at least one layer of at least a first three-dimensional article are fused with a first electron beam from the first electron beam source and the scan lines in at least one layer of at least a second three- dimensional article is fused with a second energy beam from the second energy beam source. By the inventive method it may be possible to manufacture simultaneously two three-dimensional article with two different energy beam sources, a first energy beam source for fusing the first three-dimensional article and a second energy beam source for fusing the second three- dimensional article. Alternatively the first and second energy beam sources are used alternating for the first and second three-dimensional article, i.e., the first and second energy beam are used for fusing powder layer in both sad first and second three-dimensional article.

The powder hoppers 4, 14 comprise the powder material to be provided on the build platform 2 in the build tank 10. The powder material may for instance be pure metals or metal alloys such as titanium, titanium alloys, aluminum, aluminum alloys, stainless steel, Co-Cr alloys, nickel based super alloys etc.

Instead of two powder hoppers as depicted in Figure 1 only one powder hopper may be used. Alternatively powder may be provided by other known methods for instance, one or two powder storage(s) beside the build container with a height adjustable platform for delivering a predetermined amount of powder by adjusting the height of the height adjustable platform. Powder is then raked from the powder container to the build container by a doctor blade or a powder rake.

The powder distributor 28 is arranged to lay down a thin layer of the powder material on the build platform 2. During a work cycle the build platform 2 will be lowered successively in relation to a fixed point in the vacuum chamber. In order to make this movement possible, the build platform 2 is in one embodiment of the invention arranged movably in vertical direction, i.e., in the direction indicated by arrow P. This means that the build platform 2 starts in an initial position, in which a first powder material layer of necessary thickness has been laid down. Means for lowering the build platform 2 may for instance be through a servo engine equipped with a gear, adjusting screws etc. The servo engine may be connected to the control unit 8.

After a first layer is finished, i.e., the fusion of powder material for making a first layer of the three-dimensional article, a second powder layer is provided on the build platform 2. The thickness of the second layer may be determined by the distance the build platform is lowered in relation to the position where the first layer was built. The second powder layer is typically distributed according to the same manner as the previous layer. However, there might be alternative methods in the same additive manufacturing machine for distributing powder onto the work table. For instance, a first layer may be provided by means of or via a first powder distributor 28, a second layer may be provided by another powder distributor. The design of the powder distributor is automatically changed according to instructions from the control unit 8. A powder distributor 28 in the form of a single rake system, i.e., where one rake is catching powder fallen down from both a left powder hopper 4 and a right powder hopper 14, the rake as such can change design.

After having distributed the second powder layer on the build platform, the energy beam is directed over the work table causing the second powder layer to fuse in selected locations to form a second cross section of the three-dimensional article. Fused portions in the second layer may be bonded to fused portions of the first layer. The fused portions in the first and second layer may be melted together by melting not only the powder in the uppermost layer but also remelting at least a fraction of a thickness of a layer directly below the uppermost layer.

The three-dimensional article which is formed through successive fusion of parts of a powder bed, which parts corresponds to successive cross sections of the three-dimensional article, comprising a step of providing a model of the three dimensional article. The model may be generated via a CAD (Computer Aided Design) tool.

A first powder layer may be provided on the work table 316 by distributing powder evenly over the worktable according to several methods. One way to distribute the powder is to collect material fallen down from the hopper 306, 307 by a rake system. The rake is moved over the build tank thereby distributing the powder over the start plate. The distance between a lower part of the rake and the upper part of the start plate or previous powder layer determines the thickness of powder distributed over the start plate. The powder layer thickness can easily be adjusted by adjusting the height of the build platform 314.

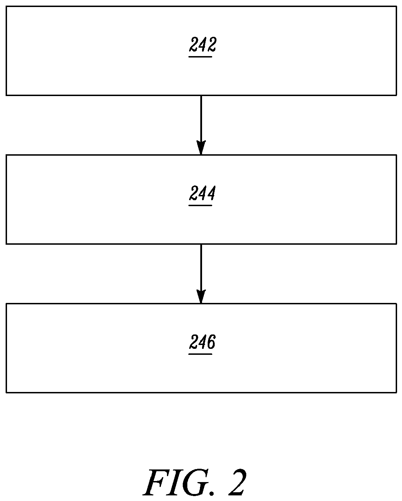

In another aspect of the invention it is provided a method for forming a three- dimensional article through successively depositing individual layers of powder material that are fused together with an electron beam from an electron beam sources so as to form the article, the method comprising a first step 242 (see Figure 2) of providing a model of the three-dimensional article. The model may be generated via a CAD (Computer Aided Design) tool.

A second step 244 of providing a vacuum chamber having at least a first and a second section, the individual layer of powder material that are fused together is provided in the first section, the at least one electron beam source is provided in the second section, wherein the first and second sections are openly connected to each other. The first section is essentially larger than the second section. In an example embodiment the second section is an electron beam column.

A third step 246 of directing an electron beam from the at least one electron beam source over the work table to fuse in first selected locations according to the model to form a first cross section of the three-dimensional article while supplying a gas to the second section of the vacuum chamber, wherein a mean pressure in the second section is higher than or equal to a mean pressure in the first section while forming the three-dimensional article. The second section may be an electron beam column.

In another aspect of the invention it is provided a program element configured and arranged when executed on a computer to implement a method as described herein. The program element may be installed in a computer readable storage medium. The computer readable storage medium may be any one of the control units described elsewhere herein or another and separate control unit, as may be desirable. The computer readable storage medium and the program element, which may comprise computer-readable program code portions embodied therein, may further be contained within a non-transitory computer program product. Further details regarding these features and configurations are provided, in turn, below.

As mentioned, various embodiments of the present invention may be implemented in various ways, including as non-transitory computer program products. A computer program product may include a non-transitory computer-readable storage medium storing applications, programs, program modules, scripts, source code, program code, object code, byte code, compiled code, interpreted code, machine code, executable instructions, and/or the like (also referred to herein as executable instructions, instructions for execution, program code, and/or similar terms used herein interchangeably). Such non-transitory computer-readable storage media include all computer-readable media (including volatile and non-volatile media).

In one embodiment, a non-volatile computer-readable storage medium may include a floppy disk, flexible disk, hard disk, solid-state storage (SSS) (e.g., a solid state drive (SSD), solid state card (SSC), solid state module (SSM)), enterprise flash drive, magnetic tape, or any other non-transitory magnetic medium, and/or the like. A non-volatile computer-readable storage medium may also include a punch card, paper tape, optical mark sheet (or any other physical medium with patterns of holes or other optically recognizable indicia), compact disc read only memory (CD-ROM), compact disc compact disc-rewritable (CD-RW), digital versatile disc (DVD), Blu-ray disc (BD), any other non-transitory optical medium, and/or the like. Such a nonvolatile computer-readable storage medium may also include read-only memory (ROM), programmable read-only memory (PROM), erasable programmable read-only memory (EPROM), electrically erasable programmable read-only memory (EEPROM), flash memory (e.g., Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may also include conductive-bridging random access memory (CBRAM), phase-change random access memory (PRAM), ferroelectric random-access memory (FeRAM), non-volatile random-access memory (NVRAM), magnetoresistive random-access memory (MRAM), resistive random-access memory (RRAM), Silicon-Oxide -Nitride-Oxide-Silicon memory (SONOS), floating junction gate random access memory (FJG RAM), Millipede memory, racetrack memory, and/or the like.

In one embodiment, a volatile computer-readable storage medium may include random access memory (RAM), dynamic random access memory (DRAM), static random access memory (SRAM), fast page mode dynamic random access memory (FPM DRAM), extended data-out dynamic random access memory (EDO DRAM), synchronous dynamic random access memory (SDRAM), double data rate synchronous dynamic random access memory (DDR SDRAM), double data rate type two synchronous dynamic random access memory (DDR2 SDRAM), double data rate type three synchronous dynamic random access memory (DDR3 SDRAM), Rambus dynamic random access memory (RDRAM), Twin Transistor RAM (TTRAM), Thyristor RAM (T-RAM), Zero-capacitor (Z-RAM), Rambus in-line memory module (RIMM), dual in-line memory module (DIMM), single in-line memory module (SIMM), video random access memory VRAM, cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present invention may also be implemented as methods, apparatus, systems, computing devices, computing entities, and/or the like, as have been described elsewhere herein. As such, embodiments of the present invention may take the form of an apparatus, system, computing device, computing entity, and/or the like executing instructions stored on a computer-readable storage medium to perform certain steps or operations. However, embodiments of the present invention may also take the form of an entirely hardware embodiment performing certain steps or operations.

Various embodiments are described below with reference to block diagrams and flowchart illustrations of apparatuses, methods, systems, and computer program products. It should be understood that each block of any of the block diagrams and flowchart illustrations, respectively, may be implemented in part by computer program instructions, e.g., as logical steps or operations executing on a processor in a computing system. These computer program instructions may be loaded onto a computer, such as a special purpose computer or other programmable data processing apparatus to produce a specifically-configured machine, such that the instructions which execute on the computer or other programmable data processing apparatus implement the functions specified in the flowchart block or blocks.

These computer program instructions may also be stored in a computer-readable memory that can direct a computer or other programmable data processing apparatus to function in a particular manner, such that the instructions stored in the computer-readable memory produce an article of manufacture including computer-readable instructions for implementing the functionality specified in the flowchart block or blocks. The computer program instructions may also be loaded onto a computer or other programmable data processing apparatus to cause a series of operational steps to be performed on the computer or other programmable apparatus to produce a computer-implemented process such that the instructions that execute on the computer or other programmable apparatus provide operations for implementing the functions specified in the flowchart block or blocks.

Accordingly, blocks of the block diagrams and flowchart illustrations support various combinations for performing the specified functions, combinations of operations for performing the specified functions and program instructions for performing the specified functions. It should also be understood that each block of the block diagrams and flowchart illustrations, and combinations of blocks in the block diagrams and flowchart illustrations, could be implemented by special purpose hardware -based computer systems that perform the specified functions or operations, or combinations of special purpose hardware and computer instructions.

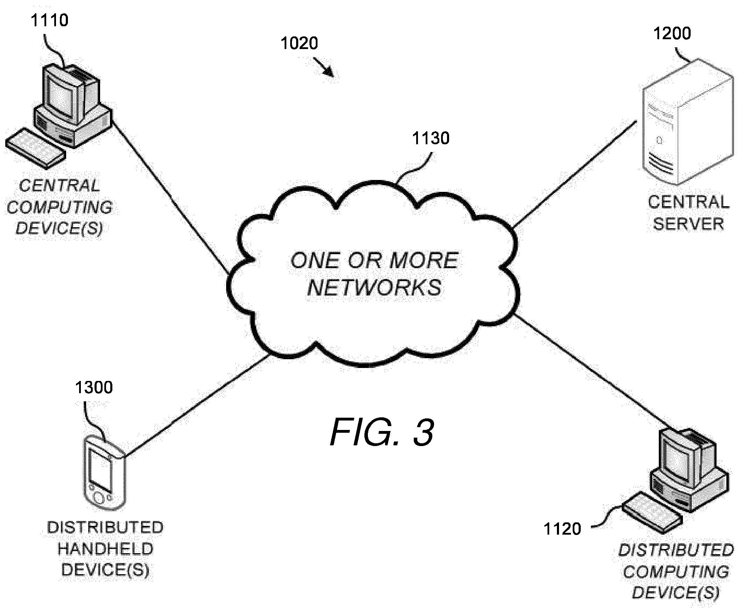

Figure 3 is a block diagram of an exemplary system 1020 that can be used in conjunction with various embodiments of the present invention. In at least the illustrated embodiment, the system 1020 may include one or more central computing devices 1110, one or more distributed computing devices 1120, and one or more distributed handheld or mobile devices 1300, all configured in communication with a central server 1200 (or control unit) via one or more networks 1130. While Figure 3 illustrates the various system entities as separate, standalone entities, the various embodiments are not limited to this particular architecture.

According to various embodiments of the present invention, the one or more networks 1130 may be capable of supporting communication in accordance with any one or more of a number of second-generation (2G), 2.5G, third-generation (3G), and/or fourth- generation (4G) mobile communication protocols, or the like. More particularly, the one or more networks 1130 may be capable of supporting communication in accordance with 2G wireless communication protocols IS-136 (TDMA), GSM, and IS-95 (CDMA). Also, for example, the one or more networks 1130 may be capable of supporting communication in accordance with 2.5G wireless communication protocols GPRS, Enhanced Data GSM Environment (EDGE), or the like. In addition, for example, the one or more networks 1130 may be capable of supporting communication in accordance with 3G wireless communication protocols such as Universal Mobile Telephone System (UMTS) network employing Wideband Code Division Multiple Access (WCDMA) radio access technology. Some narrow-band AMPS (NAMPS), as well as TACS, network(s) may also benefit from embodiments of the present invention, as should dual or higher mode mobile stations (e.g., digital/analog or TDMA/CDMA/analog phones). As yet another example, each of the components of the system 1020 may be configured to communicate with one another in accordance with techniques such as, for example, radio frequency (RF), Bluetooth^{™}, infrared (IrDA), or any of a number of different wired or wireless networking techniques, including a wired or wireless Personal Area Network ("PAN"), Local Area Network ("LAN"), Metropolitan Area Network ("MAN"), Wide Area Network ("WAN"), or the like.

Although the device(s) 1110-1300 are illustrated in Figure 3 as communicating with one another over the same network 1130, these devices may likewise communicate over multiple, separate networks.

According to one embodiment, in addition to receiving data from the server 1200, the distributed devices 1110, 1120, and/or 1300 may be further configured to collect and transmit data on their own. In various embodiments, the devices 1110, 1120, and/or 1300 may be capable of receiving data via one or more input units or devices, such as a keypad, touchpad, barcode scanner, radio frequency identification (RFID) reader, interface card (e.g., modem, etc.) or receiver. The devices 1110, 1120, and/or 1300 may further be capable of storing data to one or more volatile or non-volatile memory modules, and outputting the data via one or more output units or devices, for example, by displaying data to the user operating the device, or by transmitting data, for example over the one or more networks 1130.

In various embodiments, the server 1200 includes various systems for performing one or more functions in accordance with various embodiments of the present invention, including those more particularly shown and described herein. It should be understood, however, that the server 1200 might include a variety of alternative devices for performing one or more like functions, without departing from the spirit and scope of the present invention. For example, at least a portion of the server 1200, in certain embodiments, may be located on the distributed device(s) 1110, 1120, and/or the handheld or mobile device(s) 1300, as may be desirable for particular applications. As will be described in further detail below, in at least one embodiment, the handheld or mobile device(s) 1300 may contain one or more mobile applications 1330 which may be configured so as to provide a user interface for communication with the server 1200, all as will be likewise described in further detail below.

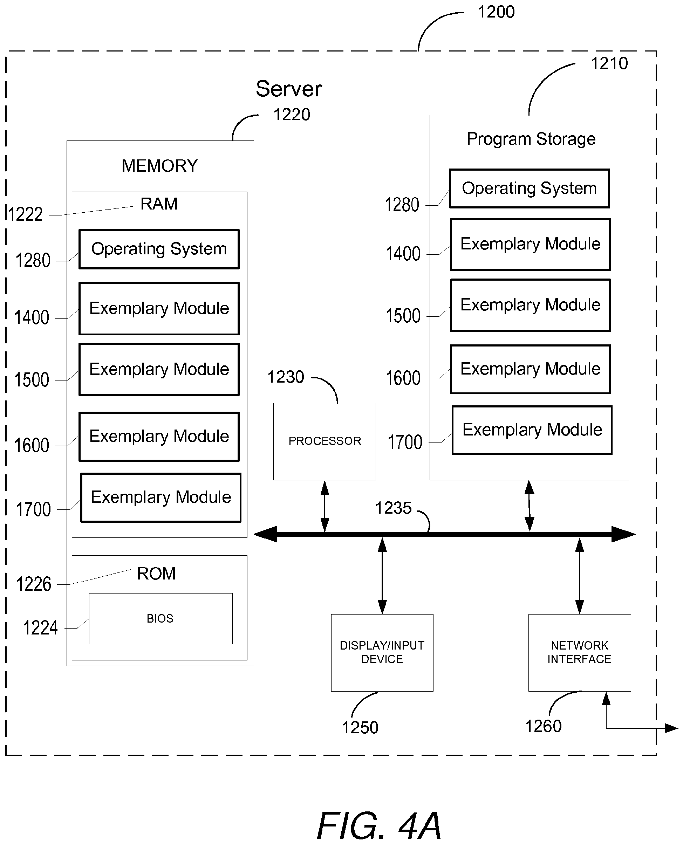

Figure 4A is a schematic diagram of the server 1200 according to various embodiments. The server 1200 includes a processor 1230 that communicates with other elements within the server via a system interface or bus 1235. Also included in the server 1200 is a display/input device 1250 for receiving and displaying data. This display/input device 1250 may be, for example, a keyboard or pointing device that is used in combination with a monitor. The server 1200 further includes memory 1220, which typically includes both read only memory (ROM) 1226 and random access memory (RAM) 1222. The server's ROM 1226 is used to store a basic input/output system 1224 (BIOS), containing the basic routines that help to transfer information between elements within the server 1200. Various ROM and RAM configurations have been previously described herein.

In addition, the server 1200 includes at least one storage device or program storage 210, such as a hard disk drive, a floppy disk drive, a CD Rom drive, or optical disk drive, for storing information on various computer-readable media, such as a hard disk, a removable magnetic disk, or a CD-ROM disk. As will be appreciated by one of ordinary skill in the art, each of these storage devices 1210 are connected to the system bus 1235 by an appropriate interface. The storage devices 1210 and their associated computer-readable media provide nonvolatile storage for a personal computer. As will be appreciated by one of ordinary skill in the art, the computer-readable media described above could be replaced by any other type of computer-readable media known in the art. Such media include, for example, magnetic cassettes, flash memory cards, digital video disks, and Bernoulli cartridges.

Although not shown, according to an embodiment, the storage device 1210 and/or memory of the server 1200 may further provide the functions of a data storage device, which may store historical and/or current delivery data and delivery conditions that may be accessed by the server 1200. In this regard, the storage device 1210 may comprise one or more databases. The term "database" refers to a structured collection of records or data that is stored in a computer system, such as via a relational database, hierarchical database, or network database and as such, should not be construed in a limiting fashion.

A number of program modules (e.g., exemplary modules 1400-1700) comprising, for example, one or more computer-readable program code portions executable by the processor 1230, may be stored by the various storage devices 1210 and within RAM 1222. Such program modules may also include an operating system 1280. In these and other embodiments, the various modules 1400, 1500, 1600, 1700 control certain aspects of the operation of the server 1200 with the assistance of the processor 1230 and operating system 1280. In still other embodiments, it should be understood that one or more additional and/or alternative modules may also be provided, without departing from the scope and nature of the present invention.

In various embodiments, the program modules 1400, 1500, 1600, 1700 are executed by the server 1200 and are configured to generate one or more graphical user interfaces, reports, instructions, and/or notifications/alerts, all accessible and/or transmittable to various users of the system 1020. In certain embodiments, the user interfaces, reports, instructions, and/or notifications/alerts may be accessible via one or more networks 1130, which may include the Internet or other feasible communications network, as previously discussed.

In various embodiments, it should also be understood that one or more of the modules 1400, 1500, 1600, 1700 may be alternatively and/or additionally (e.g., in duplicate) stored locally on one or more of the devices 1110, 1120, and/or 1300 and may be executed by one or more processors of the same. According to various embodiments, the modules 1400, 1500, 1600, 1700 may send data to, receive data from, and utilize data contained in one or more databases, which may be comprised of one or more separate, linked and/or networked databases.

Also located within the server 1200 is a network interface 1260 for interfacing and communicating with other elements of the one or more networks 1130. It will be appreciated by one of ordinary skill in the art that one or more of the server 1200 components may be located geographically remotely from other server components. Furthermore, one or more of the server 1200 components may be combined, and/or additional components performing functions described herein may also be included in the server.

While the foregoing describes a single processor 1230, as one of ordinary skill in the art will recognize, the server 1200 may comprise multiple processors operating in conjunction with one another to perform the functionality described herein. In addition to the memory 1220, the processor 1230 can also be connected to at least one interface or other means for displaying, transmitting and/or receiving data, content or the like. In this regard, the interface(s) can include at least one communication interface or other means for transmitting and/or receiving data, content or the like, as well as at least one user interface that can include a display and/or a user input interface" as will be described in further detail below. The user input interface, in turn, can comprise any of a number of devices allowing the entity to receive data from a user, such as a keypad, a touch display, a joystick or other input device.

Still further, while reference is made to the "server" 1200, as one of ordinary skill in the art will recognize, embodiments of the present invention are not limited to traditionally defined server architectures. Still further, the system of embodiments of the present invention is not limited to a single server, or similar network entity or mainframe computer system. Other similar architectures including one or more network entities operating in conjunction with one another to provide the functionality described herein may likewise be used without departing from the spirit and scope of embodiments of the present invention. For example, a mesh network of two or more personal computers (PCs), similar electronic devices, or handheld portable devices, collaborating with one another to provide the functionality described herein in association with the server 1200 may likewise be used without departing from the spirit and scope of embodiments of the present invention.

According to various embodiments, many individual steps of a process may or may not be carried out utilizing the computer systems and/or servers described herein, and the degree of computer implementation may vary, as may be desirable and/or beneficial for one or more particular applications.

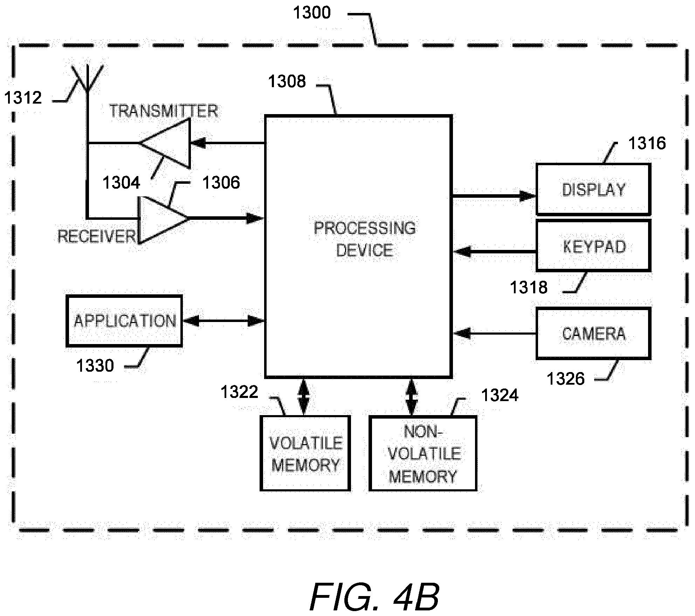

Figure 4B provides an illustrative schematic representative of a mobile device 1300 that can be used in conjunction with various embodiments of the present invention. Mobile devices 1300 can be operated by various parties. As shown in Figure 4B, a mobile device 1300 may include an antenna 1312, a transmitter 1304 (e.g., radio), a receiver 1306 (e.g., radio), and a processing element 1308 that provides signals to and receives signals from the transmitter 1304 and receiver 1306, respectively.

The signals provided to and received from the transmitter 1304 and the receiver 1306, respectively, may include signaling data in accordance with an air interface standard of applicable wireless systems to communicate with various entities, such as the server 1200, the distributed devices 1110, 1120, and/or the like. In this regard, the mobile device 1300 may be capable of operating with one or more air interface standards, communication protocols, modulation types, and access types. More particularly, the mobile device 1300 may operate in accordance with any of a number of wireless communication standards and protocols. In a particular embodiment, the mobile device 1300 may operate in accordance with multiple wireless communication standards and protocols, such as GPRS, UMTS, CDMA2000, lxRTT, WCDMA, TD-SCDMA, LTE, E-UTRAN, EVDO, HSPA, HSDPA, Wi-Fi, WiMAX, UWB, IR protocols, Bluetooth protocols, USB protocols, and/or any other wireless protocol.

Via these communication standards and protocols, the mobile device 1300 may according to various embodiments communicate with various other entities using concepts such as Unstructured Supplementary Service data (USSD), Short Message Service (SMS), Multimedia Messaging Service (MMS), Dual-Tone MultiFrequency Signaling (DTMF), and/or Subscriber Identity Module Dialer (SIM dialer). The mobile device 1300 can also download changes, addons, and updates, for instance, to its firmware, software (e.g., including executable instructions, applications, program modules), and operating system.

According to one embodiment, the mobile device 1300 may include a location determining device and/or functionality. For example, the mobile device 1300 may include a GPS module adapted to acquire, for example, latitude, longitude, altitude, geocode, course, and/or speed data. In one embodiment, the GPS module acquires data, sometimes known as ephemeris data, by identifying the number of satellites in view and the relative positions of those satellites.

The mobile device 1300 may also comprise a user interface (that can include a display 1316 coupled to a processing element 1308) and/or a user input interface (coupled to a processing element 308). The user input interface can comprise any of a number of devices allowing the mobile device 1300 to receive data, such as a keypad 1318 (hard or soft), a touch display, voice or motion interfaces, or other input device. In embodiments including a keypad 1318, the keypad can include (or cause display of) the conventional numeric (0-9) and related keys (#, *), and other keys used for operating the mobile device 1300 and may include a full set of alphabetic keys or set of keys that may be activated to provide a full set of alphanumeric keys. In addition to providing input, the user input interface can be used, for example, to activate or deactivate certain functions, such as screen savers and/or sleep modes.

The mobile device 1300 can also include volatile storage or memory 1322 and/or non-volatile storage or memory 1324, which can be embedded and/or may be removable. For example, the non-volatile memory may be ROM, PROM, EPROM, EEPROM, flash memory, MMCs, SD memory cards, Memory Sticks, CBRAM, PRAM, FeRAM, RRAM, SONOS, racetrack memory, and/or the like. The volatile memory may be RAM, DRAM, SRAM, FPM DRAM, EDO DRAM, SDRAM, DDR SDRAM, DDR2 SDRAM, DDR3 SDRAM, RDRAM, RIMM, DIMM, SIMM, VRAM, cache memory, register memory, and/or the like. The volatile and non-volatile storage or memory can store databases, database instances, database mapping systems, data, applications, programs, program modules, scripts, source code, object code, byte code, compiled code, interpreted code, machine code, executable instructions, and/or the like to implement the functions of the mobile device 1300.

The mobile device 1300 may also include one or more of a camera 1326 and a mobile application 1330. The camera 1326 may be configured according to various embodiments as an additional and/or alternative data collection feature, whereby one or more items may be read, stored, and/or transmitted by the mobile device 1300 via the camera. The mobile application 1330 may further provide a feature via which various tasks may be performed with the mobile device 1300. Various configurations may be provided, as may be desirable for one or more users of the mobile device 1300 and the system 1020 as a whole.

The invention is not limited to the above-described embodiments and many modifications are possible within the scope of the following claims. Other materials than metallic powder may be used, such as the non-limiting examples of: electrically conductive polymers and powder of electrically conductive ceramics.

## Claims

1. A method for forming a three-dimensional article through successively depositing individual layers of powder material that are fused together with an electron beam from an electron beam source so as to form the article, the method comprising the steps of:
providing a model of the three-dimensional article;
providing a vacuum chamber having at least a first and a second section, said individual layer of powder material that are fused together is provided in said first section, said at least one electron beam source comprises an electron gun or a linear accelerator and is provided in said second section, wherein said first and second sections are openly connected to each other; and
directing an electron beam from said at least one electron beam source over a work table to fuse in first selected locations according to said model to form a first cross section of said three-dimensional article while supplying a gas to said second section of said vacuum chamber, wherein a mean pressure in said second section is at least one of higher than or equal to a mean pressure in said first section while forming said three-dimensional article, wherein a cathode in said electron beam source is made of a rare earth metal hexaboride, wherein said gas is hydrogen gas for stimulating electron emission from said cathode.

2. The method according to claim 1, wherein said second section is an electron beam column.

3. The method according to claim 1, wherein said rare earth metal hexaboride is Lanthanum hexaboride.

4. The method according to claim 1, wherein a first electron beam source is provided in said second section, which second section is provided with a gas inlet and wherein a second electron beam source is provided in a third section lacking said gas inlet, wherein said third section is openly connected to said first section.

5. The method according to claim 4, wherein at least one scan line in at least a first layer of at least a first three-dimensional article is fused with a first electron beam from said first electron beam source and at least one scan line in a second layer of said at least first three-dimensional article is fused with a second energy beam from said second energy beam source.

6. The method according to claim 5, wherein said first electron beam is used for melting and/or fusing said powder material and said second energy beam source is used for pre heating said powder material and/or post heat treatment of already fused powder material.

7. The method according to claim 4, wherein the scan lines in at least one layer of at least a first three-dimensional article are fused with a first electron beam from said first electron beam source and the scan lines in at least one layer of at least a second three-dimensional article is fused with a second energy beam from said second energy beam source.

8. The method according to claim 1, wherein: the method further comprises the step of receiving and storing, within one or more memory storage areas, said model of said three-dimensional article; and at least the step of directing said electron beam is performed via execution of a program element by one or more computer processors.

9. A program element configured and arranged when executed on a computer to implement a method for forming a three-dimensional article through successively depositing individual layers of powder material that are fused together so as to form the article, said method comprising the steps of:
providing a model of said three-dimensional article; and
directing an electron beam from at least one electron beam source over a powder bed provided on a work table inside a first section of a vacuum chamber to fuse said powder bed in first selected locations according to said model to form a first cross section of said three-dimensional article while supplying a predetermined amount of a gas to a second section of said vacuum chamber where said electron beam source is provided, wherein said first and second sections are openly connected to each other, wherein a mean pressure in said second section is at least one of higher than or equal to a mean pressure in said first section while forming said three-dimensional article, wherein the electron beam source comprises an electron gun or a linear accelerator, wherein a cathode in said electron beam source is made of a rare earth metal hexaboride, wherein said gas is hydrogen gas for stimulating electron emission from said cathode.

10. A non-transitory computer readable medium having stored thereon the program element according to claim 9.

11. An apparatus for forming a three-dimensional article through successively depositing individual layers of powder material that are fused together with an electron beam from an electron beam source comprising a cathode and an anode so as to form the article based at least in part upon a computer model thereof, said apparatus comprising:
a vacuum chamber having at least a first and a second section, said individual layers of powder material that are fused together are provided in said first section, said at least one electron beam source comprises an electron gun or a linear accelerator and is provided in said second section, wherein said first and second sections are openly connected to each other;
a gas inlet provided on said second section for providing a predetermined amount of a predetermined type of gas into said second section of the vacuum chamber; and
a control unit for controlling the amount of gas provided into said second section, wherein said cathode in said electron beam source is made of a rare earth metal hexaboride, wherein said gas is hydrogen gas stored in a gas tank and connected to the second section of the vacuum chamber via a pipe for stimulating electron emission from said cathode.

12. The apparatus according to claim 11, wherein said second section is an electron beam column.

13. The apparatus according to claim 12, wherein said gas inlet is provided on said electron beam column at a position above said anode.

## Patentansprüche

1. Verfahren zur Bildung eines dreidimensionalen Gegenstandes durch sukzessive Ablagerung einzelner Schichten von Pulvermaterial, die mit einem Elektronenstrahl aus einer Elektronenstrahlquelle verschmolzen werden, um den Gegenstand zu bilden, wobei das Verfahren folgende Schritte umfasst:
Bereitstellung eines Modells des dreidimensionalen Artikels;
Bereitstellung einer Vakuumkammer mit mindestens einem ersten und einem zweiten Abschnitt, die einzelne Schicht von Pulvermaterial, die miteinander verschmolzen sind, ist in dem ersten Abschnitt vorgesehen, wobei mindestens eine Elektronenstrahlquelle eine Elektronenpistole oder einen linearen Beschleuniger umfasst und in diesem zweiten Abschnitt vorgesehen ist, wobei der erste und zweite Abschnitt offen miteinander verbunden sind; und
Anweisung eines Elektronenstrahls von mindestens einer Elektronenstrahlquelle über einen Arbeitstisch, um an den ersten ausgewählten Stellen gemäß dem Modell einen ersten Querschnitt des dreidimensionalen Artikels zu bilden, während er ein Gas an den zweiten Abschnitt der Vakuumkammer liefert, wobei ein mittlerer Druck in dem zweiten Abschnitt mindestens einer von einem mittleren Druck in dem ersten Abschnitt ist, während er den dreidimensionalen Artikel bildet, wobei eine Kathode in der Elektronenstrahlquelle aus einem seltenen Erdmetall-Hexaborid besteht, wobei das Gas Wasserstoffgas zur Stimulierung der Elektronenemission von der Kathode ist.

2. Verfahren nach Anspruch 1, wobei der zweite Abschnitt eine Elektronenstrahlsäule ist.

3. Verfahren nach Anspruch 1, wobei das Seltenerdmetall Hexaborid Lanthanum Hexaborid ist.

4. Verfahren nach Anspruch 1, wobei eine erste Elektronenstrahlquelle in dem zweiten Abschnitt vorgesehen ist, wobei der zweite Abschnitt mit einem Gaseinlass versehen ist und wobei eine zweite Elektronenstrahlquelle in einem dritten Abschnitt vorgesehen ist, der den Gaseinlass fehlt, wobei der dritte Abschnitt offen mit dem ersten Abschnitt verbunden ist.

5. Verfahren nach Anspruch 4, wobei mindestens eine Scanlinie in mindestens einer ersten Schicht von mindestens einem ersten dreidimensionalen Gegenstand mit einem ersten Elektronenstrahl aus der ersten Elektronenstrahlquelle verschmolzen ist und mindestens eine Scanlinie in einer zweiten Schicht des mindestens ersten dreidimensionalen Gegenstandes mit einem zweiten Energiestrahl aus der zweiten Energiequelle verschmolzen ist.

6. Verfahren nach Anspruch 5, wobei der erste Elektronenstrahl zum Schmelzen und/oder Verschmelzen des Pulvermaterials verwendet wird und die zweite Energiequelle zum Vorerwärmen des Pulvermaterials und/oder nach der Wärmebehandlung von bereits geschmolzenem Pulvermaterial verwendet wird.

7. Verfahren nach Anspruch 4, wobei die Scanlinien in mindestens einer Schicht von mindestens einem ersten dreidimensionalen Gegenstand mit einem ersten Elektronenstrahl aus der ersten Elektronenstrahlquelle verschmolzen sind und die Scanlinien in mindestens einer Schicht von mindestens einem zweiten dreidimensionalen Gegenstand mit einem zweiten Energiestrahl aus der zweiten Energiestrahlquelle verschmolzen sind.

8. Verfahren nach Anspruch 1, wobei: das Verfahren umfasst ferner den Schritt des Empfangs und Speicherns, innerhalb eines oder mehrerer Speicherbereiche, das Modell des dreidimensionalen Artikels; und zumindest der Schritt der Leitung des Elektronenstrahls wird durch die Ausführung eines Programmelements durch einen oder mehrere Computerprozessoren durchgeführt.

9. Ein Programmelement, das konfiguriert und angeordnet ist, wenn es auf einem Computer ausgeführt wird, um ein Verfahren zur Bildung eines dreidimensionalen Gegenstandes durch sukzessive Ablagerung einzelner Schichten von Pulvermaterial, die miteinander verschmolzen werden, um den Artikel zu bilden, zu implementieren, die die Schritte von:
Bereitstellung eines Modells dieses dreidimensionalen Artikels; und
Anweisung eines Elektronenstrahls von mindestens einer Elektronenstrahlquelle über ein Pulverbett, das auf einem Arbeitstisch innerhalb eines ersten Abschnitts einer Vakuumkammer vorgesehen ist, um das Pulverbett an den ersten ausgewählten Stellen gemäß dem Modell zu verschmelzen, um einen ersten Querschnitt des dreidimensionalen Artikels zu bilden, wobei der erste und zweite Abschnitt offen miteinander verbunden sind, wobei ein mittlerer Druck in diesem zweiten Abschnitt mindestens einen von einem höheren oder gleich einem mittleren Druck in dem ersten Abschnitt ist, wobei der erste und zweite Abschnitt offen miteinander verbunden sind, wobei ein mittlerer Druck in diesem zweiten Abschnitt mindestens einer höheren oder gleich einem mittleren Druck in dem ersten Abschnitt ist, wobei der Elektrodenstrahl ein Elektrodämpfer ist, bei dem der Elektrodenstrahl ein Elektrodenstrahl ist,bei dem der Elektrodenstrahl ein Elektrodenstrahl ist.

10. Ein nicht-transitorisches computerlesbares Medium, das auf dem Programmelement nach Anspruch 9 gespeichert ist.

11. Vorrichtung zum Umformen eines dreidimensionalen Gegenstandes durch sukzessive Ablagerung einzelner Schichten von Pulvermaterial, die mit einem Elektronenstrahl aus einer Elektronenstrahlquelle, die eine Kathode und eine Anode umfasst, so zusammengeführt werden, dass sie den Gegenstand bilden, der zumindest teilweise auf einem Computermodell davon beruht,
eine Vakuumkammer mit mindestens einem ersten und einem zweiten Abschnitt, die einzelnen Schichten von Pulvermaterial, die miteinander verschmolzen sind, sind in dem ersten Abschnitt vorgesehen, wobei mindestens eine Elektronenstrahlquelle eine Elektronenpistole oder einen linearen Beschleuniger umfasst und in diesem zweiten Abschnitt vorgesehen ist, wobei der erste und zweite Abschnitt offen miteinander verbunden sind;
einen Gaseinlass, der auf dem zweiten Abschnitt für die Bereitstellung einer vorbestimmten Menge eines vorbestimmten Gastyps in den zweiten Abschnitt der Vakuumkammer vorgesehen ist; und
eine Steuereinheit zur Steuerung der Gasmenge, die in den zweiten Abschnitt vorgesehen ist, wobei die Kathode in der Elektronenstrahlquelle aus einem Seltenerdmetall Hexaborid besteht, wobei das Gas Wasserstoffgas ist, das in einem Gastank gespeichert und mit dem zweiten Abschnitt der Vakuumkammer über ein Rohr zur Stimulierung der Elektronenemission von der Kathode verbunden ist.

12. Vorrichtung nach Anspruch 11, wobei der zweite Abschnitt eine Elektronenstrahlsäule ist.

13. Vorrichtung nach Anspruch 12, wobei der Gaseinlass auf der Elektronenstrahlsäule in einer Position oberhalb der Anode vorgesehen ist.

## Revendications

1. Une méthode pour former un article tridimensionnel en déposant successivement des couches individuelles de matière en poudre qui sont fusionnées avec un faisceau d'électrons à partir d'une source de faisceau d'électrons afin de former l'article, la méthode comprenant les étapes suivantes:
fournir un modèle de l'article tridimensionnel;
fournissant une chambre à vide ayant au moins une première et une deuxième section, ladite couche individuelle de matière en poudre qui sont fusionnées entre elles est fournie dans ladite première section, dite qu'au moins une source de faisceau d'électrons comprend un pistolet électronique ou un accélérateur linéaire et est fournie dans ladite deuxième section, où ces première et deuxième sections sont ouvertement reliées les unes aux autres; et
diriger un faisceau d'électrons à partir de ladite source de faisceau d'électrons sur une table de travail pour fusionner dans les premiers endroits sélectionnés selon ledit modèle pour former une première section transversale dudit article tridimensionnel tout en fournissant un gaz à ladite deuxième section de ladite chambre à vide, dans laquelle une pression moyenne dans ladite deuxième section est au moins supérieure ou égale à une pression moyenne dans ladite première section tout en formant ledit article tridimensionnel, dans laquelle une cathode dans ladite source de faisceau d'électrons est faite d'hexaborure de terre rare, où ledit gaz est un gaz d'hydrogène pour stimuler l'émission d'électrons de ladite cathode.

2. La méthode selon la revendication 1, dans laquelle cette deuxième section est une colonne de faisceau d'électrons.

3. La méthode selon la revendication 1, dans laquelle ledit hexaborure de terre rare est l'hexaborure de Lanthanum.

4. La méthode selon la revendication 1, selon laquelle une première source de faisceau d'électrons est fournie dans ladite deuxième section, la deuxième section est fournie avec une entrée de gaz et dans laquelle une deuxième source de faisceau d'électrons est fournie dans une troisième section dépourvue de cette entrée de gaz, où cette troisième section est ouvertement reliée à ladite première section.

5. La méthode selon la revendication 4, selon laquelle au moins une ligne de balayage dans au moins une première couche d'au moins un premier article tridimensionnel est fusionnée avec un premier faisceau d'électrons de ladite première source de faisceau d'électrons et au moins une ligne de balayage dans une deuxième couche dudit article tridimensionnel au moins est fusionnée avec un deuxième faisceau d'énergie de ladite deuxième source de faisceau d'énergie.

6. La méthode selon la revendication 5, dans laquelle ledit premier faisceau d'électrons est utilisé pour fusionner et/ou fusionner ledit matériau en poudre et cette deuxième source de faisceau d'énergie est utilisée pour le préchauffage dudit matériau en poudre et/ou le traitement post-thermique de la poudre déjà fusionnée.

7. La méthode selon la revendication 4, selon laquelle les lignes de balayage dans au moins une couche d'au moins un premier article tridimensionnel sont fusionnées avec un premier faisceau d'électrons de ladite première source de faisceau d'électrons et les lignes de balayage dans au moins une couche d'au moins un deuxième article tridimensionnel est fusionnée avec un second faisceau d'énergie de ladite deuxième source de faisceau d'énergie.

8. La méthode selon la revendication 1, selon laquelle: la méthode comprend en outre l'étape de réception et de stockage, dans une ou plusieurs zones de stockage de mémoire, dudit modèle de cet article tridimensionnel; et au moins l'étape de direction dudit faisceau d'électrons est effectuée par l'exécution d'un élément de programme par un ou plusieurs processeurs informatiques.

9. Un élément de programme configuré et arrangé lorsqu'il est exécuté sur un ordinateur pour mettre en oeuvre une méthode pour former un article tridimensionnel en déposant successivement des couches individuelles de matière en poudre qui sont fusionnées de manière à former l'article, cette méthode comprenant les étapes de:
fournir un modèle de cet article tridimensionnel; et
diriger un faisceau d'électrons à partir d'au moins une source de faisceau d'électrons sur un lit de poudre fourni sur une table de travail à l'intérieur d'une première section d'une chambre à vide pour fusionner ledit lit de poudre dans les premiers endroits sélectionnés selon ledit modèle pour former une première section de cet article tridimensionnel tout en fournissant une quantité prédéterminée d'un gaz à une deuxième section de ladite chambre à vide où ladite source de faisceau d'électrons est fournie, où lesdites sections sont ouvertement connectées les unes aux autres, où une pression moyenne dans cette seconde section est au moins une de plus ou égale à une pression moyenne dans ladite première section tout en formant ledit article en trois dimensions, où la source du faisceau d'électrons est composée d'un faisceau d'électrons ou d'un faisceau de gaz linéaire, où le faisceau d'électrons est composé d'un faisceau d'électrons d'au moins une source moyenne dans cette première section, tout en formant ledit article en trois dimensions, où le faisceau d'électronse est composé d'un faisceau d'électron d'un faisceau d'électron, un faisceau d'électron à partir d'au moins une source de faisceau d'électron d'électron sur un lit de poudre fourni sur une table de travail à l'intérieur d'une première section d'une chambre à vide pour fusionner ledit lit de poudre dans les premiers endroits sélectionnés, selon ledit modèle, pour former une première section de cet article tridimensionnel, tout en fournissant une quantité prédéterminée d'un gazon à une seconde section de ladite section est au moins une pression supérieure ou égale à une pression moyenne dans ladite première section tout en formant ledit article en trois dimensions, où le faisceau d'électrons est composé d'un faisceau d'électrons d'un faisceau de gazon, d'au moins une sourcede faisceau d'électron.

10. Un medium lisible par ordinateur non transitoire qui a été stocké sur l'élément du programme conformément à la revendication 9.

11. Appareil pour former un objet tridimensionnel en déposant successivement des couches individuelles de matière en poudre qui sont fusionnées avec un faisceau d'électrons à partir d'une source de faisceau d'électrons comprenant une cathode et une anode de manière à former l'article basé au moins en partie sur un modèle informatique de celui-ci, ledit appareil comprenant:
une chambre à vide ayant au moins une première et une deuxième section, dites couches individuelles de matière en poudre qui sont fusionnées ensemble sont fournies dans ladite première section, dit qu'au moins une source de faisceau d'électrons comprend un pistolet électronique ou un accélérateur linéaire et est fournie dans ladite deuxième section, où ces première et deuxième sections sont ouvertement connectées les unes aux autres;
une entrée de gaz prévue sur ladite deuxième section pour fournir une quantité prédéterminée d'un type de gaz prédéterminé dans cette deuxième section de la chambre à vide; et
une unité de contrôle pour contrôler la quantité de gaz fournie dans cette deuxième section, dans laquelle ladite cathode dans ladite source de faisceau d'électrons est faite d'un hexaborure de métal de terre rare, où ledit gaz est un gaz d'hydrogène stocké dans un réservoir de gaz et connecté à la deuxième section de la chambre à vide via un tuyau pour stimuler l'émission d'électrons à partir de ladite cathode.

12. L'appareil selon la revendication 11, où cette deuxième section est une colonne de faisceau d'électrons.

13. L'appareil selon la revendication 12, où ladite entrée de gaz est fournie sur ladite colonne de faisceau d'électrons à une position au-dessus de ladite anode.
